(19) 

Europäisches Patentamt

European Patent Office

Office européen des brevets

(11) **EP 4 492 085 A1**

(12) **EUROPEAN PATENT APPLICATION**
published in accordance with Art. 153(4) EPC

(43) Date of publication:
**15.01.2025 Bulletin 2025/03**

(21) Application number: 23766786.0

(22) Date of filing: 06.03.2023

(51) International Patent Classification (IPC):
*G01S 7/4863* $^{(2020.01)}$   *G01C 3/06* $^{(2006.01)}$
*G01S 17/89* $^{(2020.01)}$   *H01L 27/146* $^{(2006.01)}$

(52) Cooperative Patent Classification (CPC):
**G01C 3/06; G01S 7/4863; G01S 17/89;**
**G01S 17/894; H01L 27/146**

(86) International application number:
**PCT/JP2023/008309**

(87) International publication number:
**WO 2023/171610 (14.09.2023 Gazette 2023/37)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **08.03.2022 JP 2022034960**

(71) Applicant: **Toppan Holdings Inc.**
**Tokyo 110-0016 (JP)**

(72) Inventor: **OOKUBO Yu**
**Tokyo 110-0016 (JP)**

(74) Representative: **Plasseraud IP**
**104 Rue de Richelieu**
**CS92104**
**75080 Paris Cedex 02 (FR)**

(54) **DISTANCE IMAGE CAPTURING ELEMENT AND DISTANCE IMAGE CAPTURING DEVICE**

(57)    The present invention provides a range imaging device and a range imaging apparatus, capable of reducing the risk of a drainage failure when charge carriers are discharged. A range imaging device (range imaging sensor 32) includes a pixel circuit (321) formed at a surface of the semiconductor substrate on a semiconductor substrate. The range imaging device further includes: a photoelectric conversion device (PD) configured to generate charge carriers based on light incident from a space targeted for measurement; charge storages (CS1, CS2, CS3, CS4) configured to store at least some of the generated charge carriers; at least one transfer transistor (G1, G2, G3, G4) provided on a transfer path, the at least one transfer transistor being configured to transfer at least some of the generated charge carriers from the photoelectric conversion device to a corresponding one of the charge storages through the transfer path; and at least one charge drainage transistor (GD1 and GD2) provided on a drainage path, the at least one charge drainage transistor being configured to drain the generated charge carriers from the photoelectric conversion device through the corresponding drainage path. The photoelectric conversion device (PD) has a rectangular shape in plan view on the surface of the photoelectric conversion device, the at least one charge drainage transistor includes two charge drainage transistors (GD1 and GD2), and when, in a plan view, an axis that is parallel to long sides of the photoelectric conversion device (PD) and passes through a center of the photoelectric conversion device (PD) is set as an x-axis, and an axis that is parallel to short sides of the photoelectric conversion device (PD) and passes through the center of the photoelectric conversion device (PD) is set as a y-axis, the two charge drainage transistors (GD1 and GD2) are provided on the y-axis, and the two charge drainage transistors (GD1 and GD2) are arranged symmetrically with respect to the x-axis and face each other.

EP 4 492 085 A1

FIG.4

**Description**

[Technical Field]

The present invention relates to range imaging devices and range imaging apparatuses.

The present application is based on and claims the benefit of priority from Japanese Patent Application No. 2022-034960 filed in Japan on March 8, 2022, the contents of which are incorporated herein by reference.

[Background Art]

Conventional time-of-flight (hereinafter referred to as "TOF") range imaging sensors use the known speed of light to measure the distance between the measurement device and an object based on the time of flight of light in a space (measurement space). A TOF range imaging sensor emits a pulse of light (e.g., near-infrared light or the like) to a measurement object, and uses a difference between the time at which the light pulse is emitted and the time at which the light pulse (reflected light) reflected by the object in a measurement space is returned, that is, the time of flight of light between the measurement device and the object, to measure the distance between the measurement device and the object (see, for example, PTL 1).

When such a range imaging apparatus is used to accurately measure the distance to an object located at any distance, the quantity of charge carriers generated due to light reflected by the subject needs to be accurately read by transferring the charge carriers using a plurality of gates.

In a TOF range imaging sensor, the amount of incident light is converted into charge carriers by a photoelectric conversion device, the charge carriers obtained by conversion are stored in a charge storage, and an analog voltage corresponding to the quantity of stored charge carriers is converted into a digital value by an AD converter.

The TOF range imaging sensor obtains the distance between the measurement device and an object based on an analog voltage corresponding to the quantity of charge carriers and on information from a digital value of the time of flight of light between the measurement device and the object.

A range imaging apparatus obtains a delay time from the time at which a light pulse was emitted to the time at which the light pulse reflected by a subject was returned using the quantity of charge carriers stored in the respective charge storages. By the quantity of charge carriers stored in the respective charge storages, we mean the charge carriers stored in the charge storages as a result of the photoelectric conversion device generating charge carriers at fixed intervals. The range imaging apparatus uses the delay time and the speed of light to obtain the distance from the range imaging apparatus to the subject.

Thus, in order to transfer the charge carriers from the photoelectric conversion device to the charge storages, the photoelectric conversion device and the charge storages are provided with transfer gates (transistors) that transfer the charge carriers. Further, a drainage gate (transistor) is provided that drains the charge carriers converted by the photoelectric conversion device during a period (drainage period) in which charge carriers not stored but drained.

[Citation List]

[Patent Literature]

[PTL 1] JP 4235729 B

[Summary of the Invention]

[Problem to be Solved by the Invention]

However, depending on the positioning of the drainage gate, a drainage failure may occur that prevents the charge carriers from fully draining. For example, if the drainage gate is positioned at a distance from the center of the photoelectric conversion device, the electric potential gradient formed when the drainage gate is turned on will be more gentle than when the drainage gate is positioned near the center of the photoelectric conversion device. In this case, for example, if a large amount of external light is received during the drainage period, the charge carriers may not be fully drained from the drainage gate. Charge carriers that could not be drained from the drainage gate may enter transfer gates and be stored in charge storages, which contributes to the decrease in the accuracy of distance measurement.

The present invention has been made in view of this situation, and provides a range imaging device and a range imaging apparatus.capable of reducing the risk of a drainage failure when charge carriers are discharged.

[Solution to Problem]

To solve the above problem, a range imaging device according to a first aspect of the present invention is formed on a semiconductor substrate, the range imaging device including: a photoelectric conversion device configured to generate charge carriers based on light incident from a space targeted for measurement; charge storages each configured to store at least some of the generated charge carriers; at least one transfer transistor provided on a transfer path, the at least one transfer transistor being configured to transfer at least some of the generated charge carriers from the photoelectric conversion device to a corresponding one of the charge storages through the transfer path; and at least one charge drainage transistor provided on a drainage path, the at least one charge drainage transistor being configured to drain the generated charge carriers from the photoelectric conversion device through the drainage path, wherein a pixel circuit is formed at a surface of the semiconductor substrate, the pixel circuit including at least the photoelectric conversion device, the charge storages, the transfer transistor, and the charge drainage transistor, the photoelectric conversion device has a rectangular shape in plan view on the surface of the photoelectric conversion device, the at least one charge drainage transistor includes two charge drainage transistors, and when, in a plan view, an axis that is parallel to long sides of the photoelectric conversion device and passes through a center of the photoelectric conversion device is set as an x-axis, and an axis that is parallel to short sides of the photoelectric conversion device and passes through the center of the photoelectric conversion device is set as a y-axis, the two charge drainage transistors are provided on the y-axis, and the two charge drainage transistors are arranged symmetrically with respect to the x-axis and face each other.

In the range imaging device, the at least one transfer transistor may include 2M transfer transistors (M being an integer greater than or equal to 2), and M transfer transistors of the 2M transfer transistors may be arranged on each of long sides symmetrically with respect to the x-axis, the M transfer transistors on one of the long sides facing the M transfer transistors on the other of the long sides.

In the range imaging device, the at least one transfer transistors may have a channel length longer than that of the charge drainage transistors.

In the range imaging device, the at least one transfer transistor may have a channel region that is entirely or partially channel-doped with n-type impurities.

The range imaging device may be configured to further include a microlens facing a surface of the pixel circuit, the surface of the pixel circuit being arranged to receive the light, the microlens having an optical axis that is perpendicular to an entrance surface of the photoelectric conversion device and passes through the center of the entrance surface, the entrance surface being arranged to receive the light.

A range imaging apparatus of the present invention may include: a light receiving unit including one of the above range imaging devices; and a distance image processing unit configured to obtain a distance from the range imaging device to a subject based on a distance image captured by the range imaging device.

[Advantageous Effects of the Invention]

Therefore, according to the present invention, the risk of a drainage failure when charge carriers are discharged can be reduced.

[Brief Description of the Drawings]

Fig. 1 is a block diagram showing a schematic configuration of a range imaging apparatus of a first embodiment of the present invention.

Fig. 2 is a block diagram showing a schematic configuration of an image sensor (range imaging sensor 32) used in a range imaging apparatus 1 of the first embodiment of the present invention.

Fig. 3 is a circuit diagram showing an example configuration of pixel circuits 321 arranged in a light receiving region 320 of the range imaging sensor 32 (range imaging device) as a solid-state image sensor used in the range imaging apparatus 1 of the first embodiment of the present invention.

Fig. 4 is a diagram showing an example arrangement (layout pattern) of transistors of the pixel circuit 321 according to the first embodiment.

Fig. 5 is a diagram showing an example of a positional relationship between the photoelectric conversion device PD, the transfer transistors G, and the charge drainage transistors GD in Fig. 4.

Fig. 6A is a diagram illustrating the transfer of charge carriers from the photoelectric conversion device PD to the floating diffusions FD performed by the transfer transistors G.

Fig. 6B is a diagram illustrating a potential state in the regions of the transfer transistor G1, the photoelectric conversion device PD, and the transfer transistor G3 shown in Fig. 6A.

Fig. 7A is a diagram illustrating the drainage of charge carriers from the photoelectric conversion device PD to a power supply VDD performed by the charge drainage transistors GD.

Fig. 7B is a diagram illustrating a potential state in the regions of the charge drainage transistor GD1, the photoelectric conversion device PD, and the charge drainage transistor GD2 shown in Fig. 7A.

Fig. 8 is a diagram showing an example of a positional relationship between the photoelectric conversion device PD, transfer transistors G, and charge drainage transistors GD according to a second embodiment.

Fig. 9A is a diagram illustrating the transfer of charge carriers from the photoelectric conversion device PD to the floating diffusions FD performed by the transfer transistors G according to the second embodiment.

Fig. 9B is a diagram illustrating a potential state in the regions of the transfer transistor G1, the photoelectric conversion device PD, and the transfer transistor G3 shown in Fig. 9A.

Fig. 10 is a diagram showing an example of a positional relationship between the photoelectric conversion device PD, transfer transistors G, and charge drainage transistors GD according to a third embodiment.

Fig. 11A is a diagram illustrating the transfer of charge carriers from the photoelectric conversion device PD to the floating diffusions FD performed by the transfer transistors G according to the third embodiment.

Fig. 11B is a diagram illustrating a potential state in the regions of the transfer transistor G1, the photoelectric conversion device PD, and the transfer transistor G3 shown in Fig. 11A.

Fig. 12 is a diagram showing a positional relationship between the photoelectric conversion device PD and a microlens ML of a pixel circuit 321, according to a fourth embodiment.

Fig. 13 is a plan view showing a lens array in a portion of the light receiving region 320 in which the plurality of pixel circuits 321 are arranged.

Fig. 14 is a cross-sectional view of the lens array of the pixel circuits 321 provided with the microlenses ML in Fig. 13.

Fig. 15 is a cross-sectional view of the lens array of the pixel circuits 321 provided with the microlenses ML in Fig. 13.

[Description of the Embodiments]

<First Embodiment>

A first embodiment of the present invention will be described with reference to the drawings.

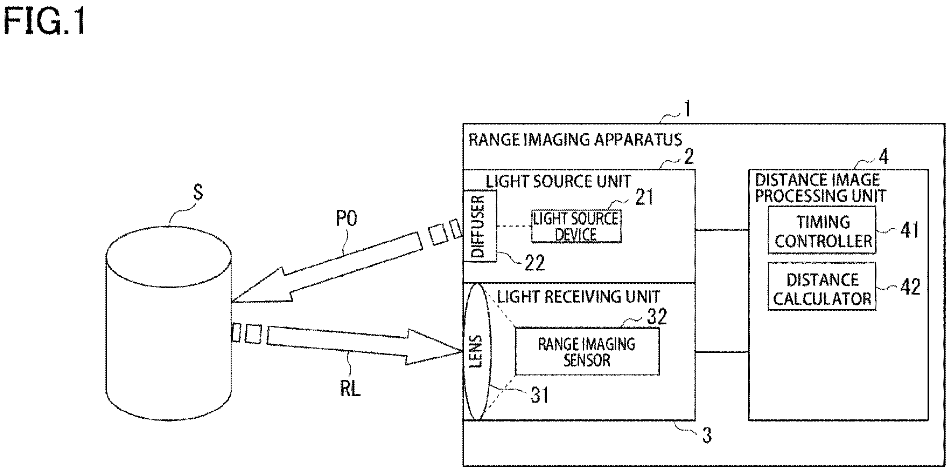

Fig. 1 is a block diagram illustrating a schematic configuration of a range imaging apparatus 1. The range imaging apparatus 1 includes a light source unit 2, a light receiving unit 3, and a distance image processing unit 4. Fig. 1 also shows a subject S as an object for which distance measurement is performed by the range imaging apparatus 1. A range imaging device may be, for example, a range imaging sensor 32 (described later) of the light receiving unit 3.

By being controlled by the distance image processing unit 4, the light source unit 2 emits a light pulse PO to a space for which image capturing is performed and in which a subject S is present as an object for which distance measurement is performed by the range imaging apparatus 1. The light source unit 2 may be, for example, a surface emitting semiconductor laser module such as a vertical cavity surface emitting laser (VCSEL). The light source unit 2 includes a light source device 21 and a diffuser 22.

The light source device 21 is a light source that emits laser light in the near-infrared wavelength region (e.g., in a wavelength range of 850 nm to 940 nm) as the light pulse PO with which the subject S is irradiated. The light source device 21 may be, for example, a semiconductor laser light emitting device. The light source device 21 emits pulsed laser light according to control by a timing controller 41.

The diffusion plate 22 is an optical component that diffuses laser light in the near-infrared wavelength region emitted from the light source device 21 over an area in which the subject S is irradiated with the diffused laser light. The pulsed laser light diffused by the diffusion plate 22 emerges as the light pulse PO, and the subject S is irradiated with the light pulse PO.

The light receiving unit 3 receives reflected light RL of the light pulse PO reflected by the subject S as an object for which distance measurement is performed by the range imaging apparatus 1, and outputs a pixel signal corresponding to the reflected light RL received. The light receiving unit 3 includes a lens 31 and the range imaging sensor 32.

The lens 31 is an optical lens that guides the reflected light RL incident on the lens 31 to the range imaging sensor 32. The reflected light RL incident on the lens 31 emerges toward the range imaging sensor 32, and is received by (incident on) pixel circuits provided in a light receiving region of the range imaging sensor 32.

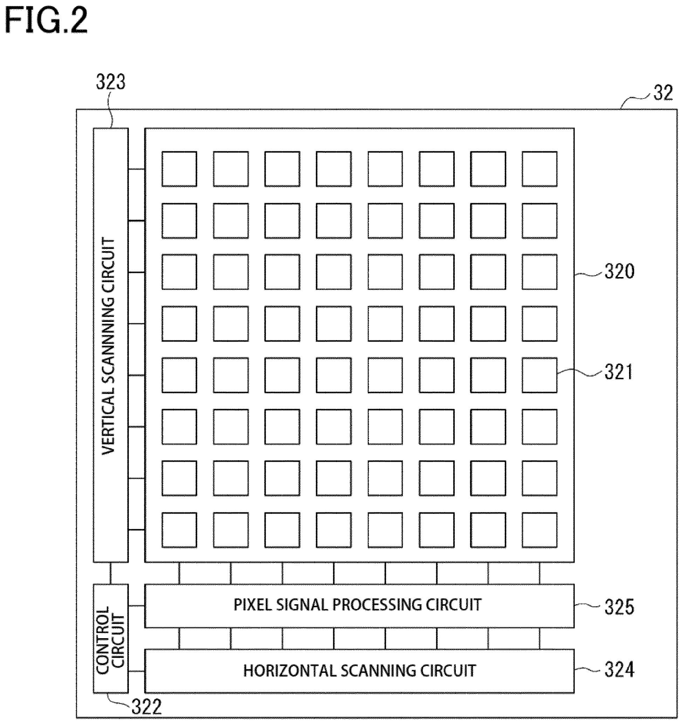

The range imaging sensor 32 is an image sensor used in the range imaging apparatus 1. As shown in Fig. 2, the range imaging sensor 32 includes a plurality of pixels in a two-dimensional light receiving region. Pixel circuits (pixel circuits 321) of the range imaging sensor 32 each include a single photoelectric conversion device, a plurality of charge storages corresponding to the single photoelectric conversion device, and components that each distribute charge carriers to a corresponding one of the charge storages.

The range imaging sensor 32 distributes charge carriers generated by the photoelectric conversion device to each of the charge storages, according to control by the timing controller 41. Furthermore, the range imaging sensor 32 outputs a pixel signal corresponding to the quantity of charge carriers distributed to each of the charge storages. In the range imaging sensor 32, the plurality of pixel circuits are arranged in a two-dimensional matrix, and the range imaging sensor 32 outputs each pixel signal for one frame for the individual pixel circuits.

The distance image processing unit 4 controls the range imaging apparatus 1 to calculate the distance to the subject S. The distance image processing unit 4 includes the timing controller 41 and a distance calculator 42.

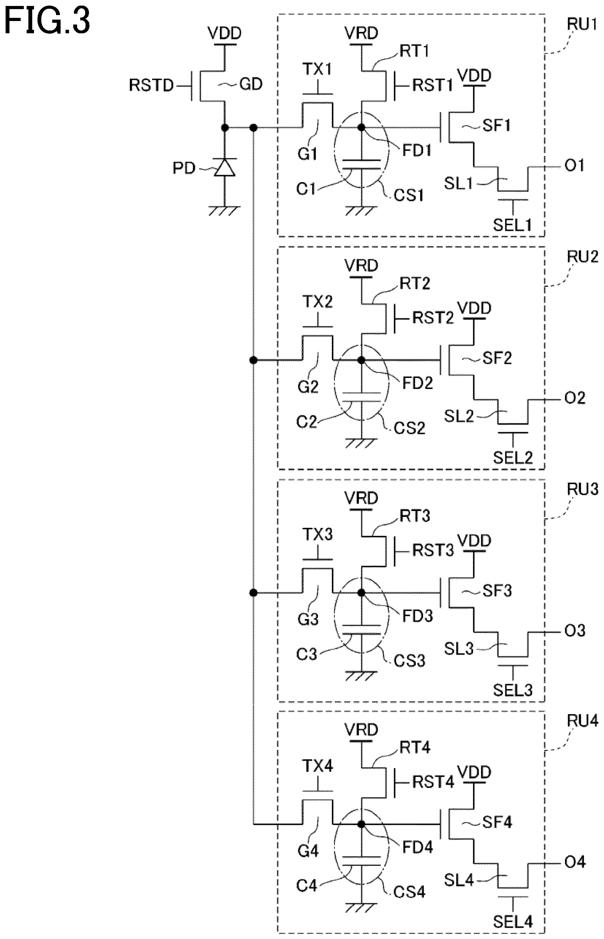

The timing controller 41 controls the timing of outputting various control signals required for distance measurement. The various control signals include, for example, a signal for controlling emission of the light pulse PO, a signal for distributing the reflected light RL to the plurality of charge storages, and a signal for controlling the number of distributions per frame. The number of distributions is the number of repetitions of the process of distributing charge carriers to charge storages CS (see Fig. 3).

The distance calculator 42 outputs distance information obtained by calculating the distance to the subject S, based on the pixel signal output from the range imaging sensor 32. The distance calculator 42 calculates a delay time Td from the time at which the light pulse PO is emitted to the time at which the reflected light RL is received, based on the quantity of charge carriers stored in the plurality of charge storages CS. The distance calculator 42 calculates the distance from the range imaging apparatus 1 to the subject S according to the calculated delay time Td.

With such a configuration, in the range imaging apparatus 1, the light pulse PO in the near-infrared wavelength region emitted from the light source unit 2 to the subject S is reflected by the subject S, and the reflected light RL is received by the light receiving unit 3, and the distance image processing unit 4 outputs distance information obtained by measuring the distance between the subject S and the range imaging apparatus 1.

Fig. 1 shows the range imaging apparatus 1 in which the distance image processing unit 4 is included; however, the distance image processing unit 4 may be a component provided outside the range imaging apparatus 1.

Next, a configuration of the range imaging sensor 32 used as an image sensor in the range imaging apparatus 1 will be described. Fig. 2 is a block diagram illustrating a schematic configuration of the image sensor (the range imaging sensor 32).

As shown in Fig. 2, the range imaging sensor 32 includes, for example, the light receiving region 320 in which the plurality of pixel circuits 321 are arranged, a control circuit 322, a vertical scanning circuit 323 that performs distribution operation, a horizontal scanning circuit 324, and a pixel signal processing circuit 325.

The light receiving region 320 is a region in which the plurality of pixel circuits 321 are arranged. Fig. 2 shows an example in which the pixel circuits 321 are arranged in a two-dimensional matrix with 8 rows and 8 columns. The pixel circuits 321 store charge carriers corresponding to the amount of light received. The control circuit 322 controls the operation of the components of the range imaging sensor 32, for example, according to instructions from the timing controller 41 of the distance image processing unit 4.

The vertical scanning circuit 323 is a circuit that controls, for each row, the pixel circuits 321 arranged in the light receiving region 320, according to control by the control circuit 322. The vertical scanning circuit 323 causes the pixel circuits 321 to output, to the pixel signal processing circuit 325, each voltage signal corresponding to the quantity of charge carriers stored in the individual charge storages CS of the pixel circuits 321.

The pixel signal processing circuit 325 performs predetermined signal processing (e.g., noise suppression processing, A/D conversion processing, etc.) to the voltage signals output from the pixel circuits 321 in each row, according to control by the control circuit 322.

The horizontal scanning circuit 324 is a circuit that causes a signal output from the pixel signal processing circuit 325 to be sequentially output in a time series manner, according to control by the control circuit 322. Thus, a pixel signal corresponding to the quantity of charge carriers stored for one frame is sequentially output to the distance image processing unit 4. The following description assumes that the pixel signal processing circuit 325 performs A/D conversion processing, and the pixel signal is a digital signal.

A configuration of the pixel circuits 321 arranged in the light receiving region 320 of the range imaging sensor 32 will be described. Fig. 3 is a circuit diagram illustrating an exemplary configuration of the pixel circuits 321. The pixel circuit 321 in Fig. 3 is a configuration example including four pixel signal reading units.

The pixel circuit 321 includes a single photoelectric conversion device PD, charge drainage transistors GD (GD1 and GD2 described later), and four pixel signal reading units RU (RU1 to RU4) each of which outputs a voltage signal from the corresponding output terminal O (O1 to O4). The pixel signal reading units RU each include a transfer transistor G, a floating diffusion FD, a charge storage capacitor C, a reset transistor RT, a source follower transistor SF, and a selection transistor SL. The floating diffusion FD and the charge storage capacitor C constitute a charge storage CS.

In the pixel circuit 321 shown in Fig. 3, the pixel signal reading unit RU1 that outputs a voltage signal from the output terminal O1 includes a transfer transistor G1 (transfer MOS transistor), a floating diffusion FD1, a charge storage capacitor C1, a reset transistor RT1, a source follower transistor SF1, and a selection transistor SL1. In the pixel signal reading unit RU1, the floating diffusion FD1 and the charge storage capacitor C1 constitute a charge storage CS1. The pixel signal reading units RU2, RU3, and RU4 also have the same configuration.

The photoelectric conversion device PD is an embedded photodiode that performs photoelectric conversion of incident light to generate charge carriers corresponding to the incident light and that stores the generated charge carriers. In the present embodiment, incident light is incident from a space to be measured.

In the pixel circuits 321, the charge carriers generated through photoelectric conversion of the incident light by the photoelectric conversion device PD are distributed to each of four charge storages CS (CS1 to CS4), and each voltage signal corresponding to the quantity of charge carriers distributed is output to the pixel signal processing circuit 325.

The configuration of the pixel circuits arranged in the range image sensor 32 is not limited to the configuration including four pixel signal readout units RU (RU1 to RU4) as illustrated in Fig. 3 and may be any configuration including 2M (M is an integer, $M \geq 2$) or more pixel signal readout units RU. That is, the pixel circuits may include 2M (M is an integer, $M \geq 2$) or more transfer transistors G.

When the pixel circuits 321 of the range imaging apparatus 1 are driven, the light pulse PO is emitted for an emission time To, and after the delay time Td, the reflected light RL is received by the range imaging sensor 32. In synchronization with emission of the light pulse PO, the vertical scanning circuit 323 transfers the charge carriers generated by the photoelectric conversion device PD to the charge storages CS1, CS2, CS3, and CS4 in this order to store the charge carriers in the charge storages.

At this time, the vertical scanning circuit 323 causes the transfer transistor G1 to be in an ON state. The transfer transistor G1 is provided on a transfer path through which charge carriers are transferred from the photoelectric conversion device PD to the charge storage CS1. Thus, charge carriers generated through photoelectric conversion by the photoelectric conversion device PD are stored in the charge storage CS1 via the transfer transistor G1. Then, the vertical scanning circuit 323 causes the transfer transistor G1 to be in an OFF state. This stops the transfer of charge carriers to the charge storage CS1. Thus, the vertical scanning circuit 323 causes charge carriers to be stored in the charge storage CS1. The same applies to the charge storages CS2, CS3, and CS4.

In this case, storage cycles are repeated in a charge storage period in which charge carriers are distributed to the charge storages CS. In the storage cycles, storage driving signals TX1, TX2, TX3, and TX4 are supplied to the transfer transistors G1, G2, G3, and G4, respectively.

Charge carriers corresponding to the incident light are transferred from the photoelectric conversion device PD to the charge storages CS1, CS2, CS3, and CS4 via the transfer transistors G1, G2, G3, and G4, respectively. A plurality of storage cycles are repeated in the charge storage period.

Thus, for the storage cycles of the charge storages CS1, CS2, CS3, and CS4 in the charge storage period, charge carriers are stored in the charge storages CS1, CS2, CS3, and CS4, respectively.

When the storage cycles of the charge storages CS1, CS2, CS3, and CS4 are repeated, after the transfer of charge carriers to the charge storage CS4 is ended, the vertical scanning circuit 323 turns on the charge drainage transistor GD provided on a drainage path through which the charge carriers are discharged from the photoelectric conversion device PD.

Thus, before the storage cycle of the charge storage CS1 is started, the charge drainage transistor GD removes the charge carriers generated by the photoelectric conversion device PD after the preceding storage cycle of the charge storage CS4 (i.e., resets the photoelectric conversion device PD).

The vertical scanning circuit 323 causes, for each row (the array in the lateral direction) of the pixel circuits 321, each of all the pixel circuits 321 arranged in the light receiving region 320 to sequentially output a voltage signal to the pixel signal processing circuit 325.

The pixel signal processing circuit 325 performs signal processing such as A/D conversion processing to each of the input voltage signals, and outputs the voltage signal subjected to the signal processing to the horizontal scanning circuit 324.

The horizontal scanning circuit 324 causes the voltage signal subjected to the signal processing to be sequentially output to the distance calculator 42 in the order of the rows in the light receiving region 320.

The vertical scanning circuit 323 repeatedly performs, over one frame, the storage of charge carriers in the charge storages CS and the removal of the charge carriers generated through photoelectric conversion by the photoelectric conversion device PD as described above. Thus, the charge carriers corresponding to the amount of light received by the range imaging apparatus 1 during a predetermined time period are stored in each of the charge storages CS. The horizontal scanning circuit 324 outputs, to the distance calculator 42, each electrical signal corresponding to the quantity of charge carriers for one frame stored in the individual charge storages CS.

Due to the relationship between the timing at which the light pulse PO is emitted and the timing at which charge carriers are stored in each of the charge storages CS (CS1 to CS4), the quantity of charge carriers corresponding to an external light component such as background light before the emission of the light pulse PO is held in the charge storage CS1. Furthermore, the quantity of charge carriers corresponding to the reflected light RL and the external light component is distributed to the charge storages CS2, CS3, and CS4 and held therein. The distribution (distribution ratio) between the quantity of charge carriers distributed to the charge storage CS2 and the quantity of charge carriers distributed to the charge storage CS3 or the distribution ratio between the quantity of charge carriers distributed to the charge storage CS3 and the quantity of charge carriers distributed to the charge storage CS4 is a ratio corresponding to the delay time Td from the time at which the light pulse PO is emitted to the time at which the light pulse PO is incident on the range imaging apparatus 1 after being reflected by the subject S.

The distance calculator 42 uses this principle to calculate the delay time Td by the following formula (1) or (2).

$$Td = To \times (Q3 - Q1)/(Q2 + Q3 - 2 \times Q1) \dots (1)$$

$$Td = To + To \times (Q4 - Q1)/(Q3 + Q4 - 2 \times Q1) \dots (2)$$

Here, To represents the period during which the light pulse PO is emitted, Q1 represents the quantity of charge carriers stored in the charge storage CS1, Q2 represents the quantity of charge carriers stored in the charge storage CS2, Q3 represents the quantity of charge carriers stored in the charge storage CS3, and Q4 represents the quantity of charge carriers stored in the charge storage CS4. For example, the distance calculator 42 uses the formula (1) to calculate the delay time Td when Q4 = Q1, and uses the formula (2) to calculate the delay time Td when Q2 = Q1.

In the formula (1), charge carriers generated from the reflected light are stored in the charge storages CS2 and CS3, but are not stored in the charge storage CS4. On the other hand, in the formula (2), charge carriers generated from the reflected light are accumulated in the charge storages CS3 and CS4, but are not stored in the charge storage CS2.

Note that, in the formula (1) or (2), the quantity of charge carriers corresponding to the external light component of the quantity of charge carriers stored in the charge storages CS2, CS3, and CS4 is assumed to be equal to the quantity of charge carriers stored in the charge storage CS1.

The distance calculator 42 multiplies the delay time obtained from the formula (1) or (2) by the speed of light (speed) to calculate the round-trip distance to and from the subject S.

Then, the distance calculator 42 calculates 1/2 of the calculated round-trip distance to obtain the distance to the subject S.

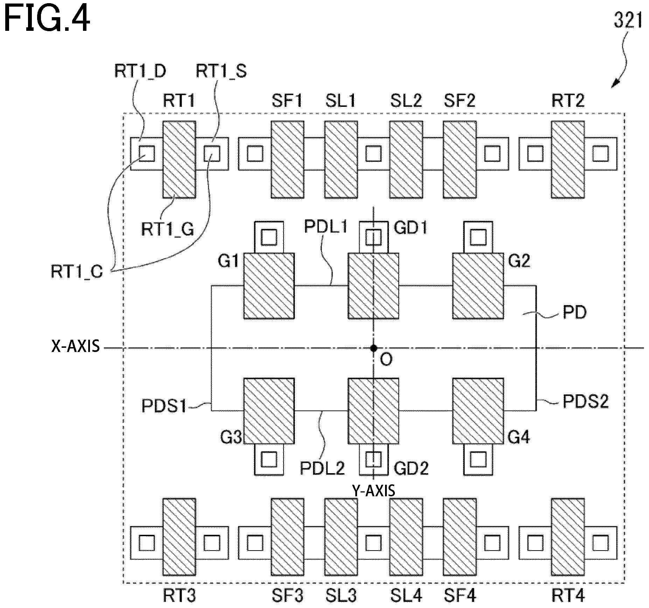

Fig. 4 is a diagram showing an example arrangement (layout pattern) of the transistors of the pixel circuits 321 according to the present embodiment.

Fig. 4 shows a layout pattern of the pixel circuits 321.

Fig. 4 shows an arrangement pattern of the transfer transistors G1, G2, G3, and G4, the source follower transistors SF1, SF2, SF3, and SF4, the selection transistors SL1, SL2, SL3, and SL4, the reset transistors RT1, RT2, RT3, and RT4, the charge drainage transistors GD1 and GD2, and the photoelectric conversion device PD. All the transistors described above are n-channel MOS transistors provided at a p-type semiconductor substrate.

For example, the reset transistor RT1 is composed of a drain RT1_D (n-type diffusion layer (diffusion layer of n-type impurities)), a source RT1_S (n-type diffusion layer), and a gate RT1_G at the p-type semiconductor substrate.

A contact RT1_C is a pattern indicating a contact that is provided in each of the diffusion layers, that is, the drain RT1_D (n-type diffusion layer) and the source RT1_S (n-type diffusion layer) of the reset transistor RT1, and that is connected to a wire (not shown). The transfer transistors G1 to G4, the source follower transistors SF1 to SF4, the selection transistors SL1 to SL4, the reset transistors RT2 to RT4, and the charge drainage transistors GD1 and GD2 also have the same configuration.

The photoelectric conversion device PD has a rectangular shape, and has a long side PDL1, a long side PDL2 facing the long side PDL1 in parallel, a short side PDS1, and a short side PDS2 facing the short side PDS1 in parallel.

In the rectangular pattern of the photoelectric conversion device PD, the x-axis is an axis that is perpendicular to the short side PDS1 (and the short side PDS2) of the rectangle (i.e., parallel to the long sides PDL1 and PDL2 of the rectangle) and that passes through a center O of the rectangle. A y-axis is an axis that is perpendicular to the x-axis, that is, perpendicular to the long side PDL1 (and the long side PDL2) of the rectangle (i.e., parallel to the short sides PDS1 and PDS2 of the rectangle), and that passes through the center O of the rectangle.

The charge drainage transistor GD1 is placed in the long side PDL1 and on the y-axis.

The charge drainage transistor GD2 is placed in the long side PDL2 and on the y-axis.

The charge drainage transistor GD2 is placed at a position symmetrical to the charge drainage transistor GD1 with respect to the x-axis. In other words, the charge drainage transistor GD2 is placed in the long side PDL2 and on the y-axis so that it is at a position symmetrical to the charge drainage transistor GD1 with respect to the x-axis.

As described above, the charge drainage transistors GD1 and GD2 are located on the y-axis and at the same distance from the x-axis. Therefore, the charge drainage transistors GD1 and GD2 are located at the same distance from the center O of the photoelectric conversion device PD.

By placing the charge drainage transistors GD1 and GD2 in the long sides PDL1 and PDL2, respectively, and on the y-axis, the distances from the center O of the photoelectric conversion device PD to the charge drainage transistors GD1 and GD2 can be reduced as compared with when the charge drainage transistors GD1 and GD2 are placed in the short sides PDS1 and PDS2, respectively. This improves the drainage characteristics and reduces the risk of a discharge failure.

The transfer transistors G1 and G2 are placed symmetrically with respect to the y-axis with the charge drainage transistor GD1 located between them.

The transfer transistors G3 and G4 are placed symmetrically with respect to the y-axis with the charge drainage transistor GD2 located between them.

The transfer transistors G3 and G4 and the transfer transistors G1 and G2 are placed symmetrically with respect to the x-axis.

Although the present embodiment is explained using an example in which the number of transfer transistors G is four, 2M (M is an integer, M ≥ 2) transfer transistors G may be provided, and M transfer transistors G may be arranged in each of the long sides PDL1 and PDL2 so that they face each other and are located symmetrically with respect to the x-axis.

As described above, the transfer transistors G1, G2, G3, and G4 are located at the same distance from the x-axis, and are also located at the same distance from the center O of the photoelectric conversion device PD.

In addition, the transfer transistors G1 to G4 have the same size (the same channel length and width), and have the same transistor characteristics.

This allows the charge carriers generated by the photoelectric conversion device PD to be transferred with the same transfer efficiency (transfer characteristics), which in turn allows the charge carriers to be stored in the charge storages CS1 to CS4 with the same transfer characteristics. As a result, the distance between the subject and the range imaging apparatus can be determined with high accuracy.

The reset transistors RT1 and RT2 and the respective reset transistors RT3 and RT4 are arranged symmetrically with respect to the x-axis.

The source follower transistors SF1 and SF2 and the respective source follower transistors SF3 and SF4 are arranged symmetrically with respect to the x-axis.

The selection transistors SL1 and SL2 and the respective selection transistors SL3 and SL4 are arranged symmetrically with respect to the x-axis.

Note that Fig. 4 shows an arrangement of the transistors of the pixel circuits 321 at the semiconductor substrate. In Fig. 4, a wiring pattern and the charge storage capacitors (C1 to C4) are omitted. Thus, the charge storages CS1, CS2, CS3, and CS4 are located at the positions of the floating diffusions FD1, FD2, FD3, and FD4, respectively.

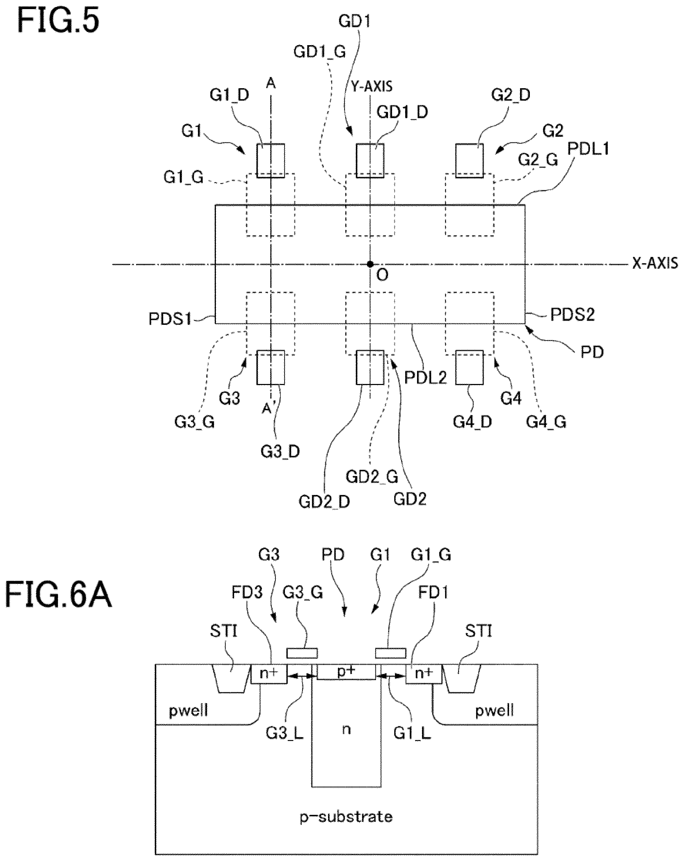

Fig. 5 is a diagram showing an example of a positional relationship between the photoelectric conversion device PD, the transfer transistors G, and the charge drainage transistors GD in Fig. 4.

Fig. 5 shows a positional relationship of the transfer transistors G1, G2, G3, and G4 and the charge drainage transistors GD1 and GD2 with respect to the photoelectric conversion device PD.

The charge drainage transistor GD1 is composed of a drain GD1_D, a gate GD1_G, and a source (n-type diffusion layer of the photoelectric conversion device PD). The drain GD1_D is connected to a power supply VDD via a contact and a wire.

In response to application of a gate voltage at the "H" level to the gate GD1_G, the charge drainage transistor GD1 transfers the charge carriers (electrons) generated by the photoelectric conversion device PD to the drain GD1_D. Then, the drain GD1_D discharges the charge carriers transferred from the photoelectric conversion device PD to the power supply VDD.

The charge drainage transistor GD2 has the same configuration as the charge drainage transistor GD1, and is composed of a drain GD2_D, a gate GD2_G, and a source (n-type diffusion layer of the photoelectric conversion device PD). The drain GD2_D is connected to the power supply VDD via a contact and a wire.

In response to application of a gate voltage at the "H" level to the gate GD2_G, the charge drainage transistor GD2 transfers the charge carriers (electrons) generated by the photoelectric conversion device PD to the drain GD2_D. Then, the drain GD2_D discharges the charge carriers transferred from the photoelectric conversion device PD to the power supply VDD.

The transfer transistor G1 is composed of the floating diffusion FD1 as a drain G1_D, a gate G1_G, and a source (n-type diffusion layer of the photoelectric conversion device PD). The floating diffusion FD1 is formed with the charge storage CS1. The drain G1_D is connected, via a contact and a wire, to each of a gate SF1_G of the source follower transistor SF1 and the source RT1_S of the reset transistor RT1.

In response to application of a gate voltage at an "H" level to the gate G1_G, the transfer transistor G1 transfers charge carriers (electrons) generated by the photoelectric conversion device PD to the floating diffusion FD1 as the drain G1_D. The floating diffusion FD1 stores the charge carriers transferred from the photoelectric conversion device PD.

The transfer transistors G2, G3, and G4 have the same configuration as the transfer transistor G1.

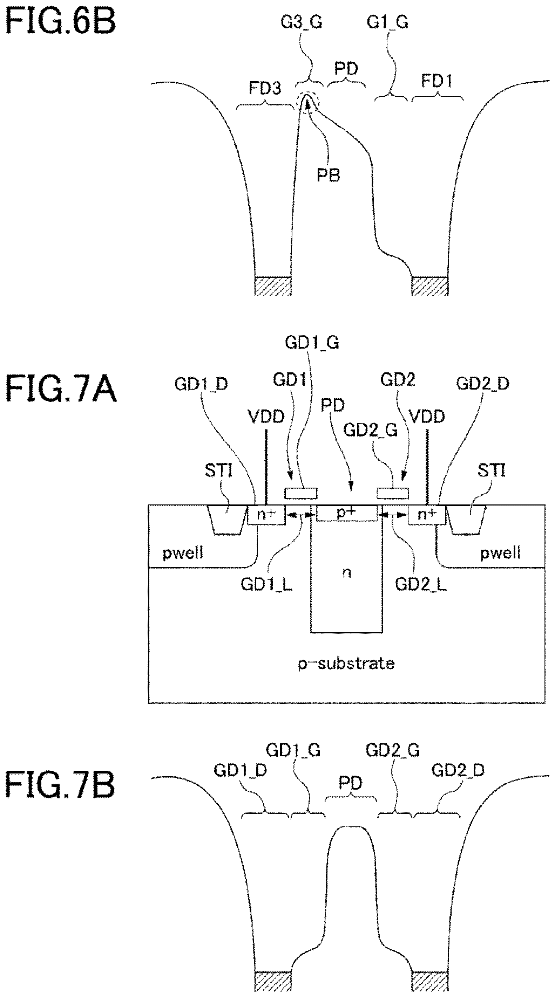

Figs. 6A and 6B are each a diagram illustrating the transfer of charge carriers from the photoelectric conversion device PD to the floating diffusions FD performed by the transfer transistors G.

Fig. 6A shows a cross-sectional structure taken along line segment A-A' of the semiconductor on which the pixel circuit 321 in Fig. 5 is provided.

The photoelectric conversion device PD may be, for example, an embedded photodiode having a p+ diffusion layer (diffusion layer of p-type impurities) as a surface protective layer at its surface.

The transfer transistor G1 includes the n-type diffusion layer of the photoelectric conversion device PD as a source, and an n+ diffusion layer of the floating diffusion FD1 as a drain.

The transfer transistor G1 is formed so that the length from the source to the drain is a channel length G1_L.

The n+ diffusion layer of the floating diffusion FD1 is adjacent to an STI (shallow trench isolation) and a p-well (p-type diffusion layer) for preventing the outflow (discharge) of charge carriers (for preventing current leakage) from the n+ diffusion layer.

In response to application of a gate voltage at the "H" level to the gate G1_G, the transfer transistor G1 transfers charge carriers (electrons) generated by the photoelectric conversion device PD to the floating diffusion FD1 as a drain. The floating diffusion FD1 stores the charge carriers transferred from the transfer transistor G1.

The transfer transistor G3 includes the n-type diffusion layer of the photoelectric conversion device PD as a source, and an n+ diffusion layer of the floating diffusion FD3 as a drain.

The transfer transistor G3 is formed so that the length from the source to the drain is a channel length G3_L.

The n+ diffusion layer of the floating diffusion FD3 is adjacent to an STI and a p-well for preventing current leakage from the n+ diffusion layer.

In response to application of a gate voltage at the "H" level to the gate G3_G, the transfer transistor G3 transfers charge carriers (electrons) generated by the photoelectric conversion device PD to the floating diffusion FD3 as a drain. The floating diffusion FD3 stores the charge carriers transferred from the transfer transistor G3.

Fig. 6B shows a potential state in the regions of the transfer transistor G1, the photoelectric conversion device PD, and the transfer transistor G3 shown in Fig. 6A. In Fig. 6B, the horizontal axis indicates a position in the regions, and the vertical axis indicates a potential level (the potential is higher at a lower position).

Fig. 6B shows a potential state when a gate voltage at the "H" level is applied to the gate G1_G of the transfer transistor G1 and a gate voltage at an "L" level is applied to the gate G3_G of the transfer transistor G3.

The gate G3_G of the transfer transistor G3 is at the "L" level; thus, a potential barrier PB is formed in the region of the gate G3_G, and no charge carriers are transferred from the photoelectric conversion device PD to the floating diffusion FD3 as a drain of the transfer transistor G3 (no electrons flow to the drain).

On the other hand, the gate G1_G of the transfer transistor G1 is at the "H" level; thus, the potential is high (no potential barrier is formed) in the region of the gate G1_G, and charge carriers are transferred from the photoelectric conversion device PD to the floating diffusion FD1 as a drain of the transfer transistor G1 (the electrons flow to the drain).

When charge carriers at the "H" level are applied to each of the gates G1_G, G2_G, G3_G, and G4_G of the transfer transistors G1, G2, G3, and G4, the potential drops from the source (the n-type diffusion layer of the photoelectric conversion device PD) to the drains G1_D, G2_D, G3_D, and G4_D have the same shape (potential slope). This is because the transfer transistors G1, G2, G3, and G4 are located at the same distance from the center O of the photoelectric conversion device PD.

That is, when the distances from the transfer transistors G1, G2, G3, and G4 to the center O of the photoelectric conversion device PD are the same, the electric fields extending in the diffusion layer from the transfer transistors G1, G2, G3, and G4 towards the center O of the photoelectric conversion device PD can have the same strength. By creating the electric fields in the diffusion layer so that they have the same strength, the potential drops in the gate G1_G, G2_G, G3_G, and G4_G regions can have the same shape.

According to this embodiment, since the transfer transistors G2 and G3 have the same shape and are placed at the same position, the charge carriers are transferred with the same transfer efficiency. Since the transfer transistors G1 and G4 also have the same shape and are placed at the same position, the charge carriers are transferred with the same transfer efficiency.

That is, when the transfer transistors G1, G2, G3, and G4 respectively transfer, for example, the same quantity of charge carriers from the photoelectric conversion device PD to the floating diffusions FD1, FD2, FD3, and FD4, the same quantity of charge carriers is stored in the floating diffusions FD1, FD2, FD3, and FD4.

Therefore, in the present embodiment, charge carriers generated by the photoelectric conversion device PD can be stored in the charge storages CS 1 to CS4 at the same transfer efficiency (with the same transfer characteristics); thus, the distance between a subject and the range imaging apparatus can be obtained with high accuracy by the formula (1) or (2) using the quantity of charge carriers stored in the charge storages CS1 to CS4.

Figs. 7A and 7B are each a diagram illustrating the drainage of charge carriers from the photoelectric conversion device PD to the power supply VDD performed by the charge drainage transistors GD.

Fig. 7A shows a cross-sectional structure taken along the y-axis of the semiconductor on which the pixel circuit 321 in Fig. 5 is provided.

The charge drainage transistor GD1 includes, as the source, the n-type diffusion layer of the photoelectric conversion device PD, and, as the drain GD1_D, the n-type diffusion layer connected to the power supply VDD.

The charge drainage transistor GD1 is formed so that the length from the source to the drain is a channel length GD1_L.

The n-type diffusion layer of the drain GD1_D is adjacent to an STI and a p-well for preventing current leakage from the n-type diffusion layer.

In response to application of a gate voltage at the "H" level to a gate GD1_G, the charge drainage transistor GD1 transfers the charge carriers (electrons) generated by the photoelectric conversion device PD to the drain GD1_D (discharges the charge carriers of the photoelectric conversion device PD to the power supply VDD).

The charge drainage transistor GD2 includes, as the source, the n-type diffusion layer of the photoelectric conversion device PD, and, as the drain GD2_D, the n-type diffusion layer connected to the power supply VDD.

The charge drainage transistor GD2 is formed so that the length from the source to the drain is a channel length GD2_L.

The n-type diffusion layer of the drain GD2_D is adjacent to an STI and a p-well for preventing current leakage from the n-type diffusion layer.

In response to application of a gate voltage at the "H" level to a gate GD2_G, the charge drainage transistor GD2 transfers the charge carriers generated by the photoelectric conversion device PD to the drain GD2_D.

Fig. 7B shows a potential state in the regions of the charge drainage transistor GD1, the photoelectric conversion device PD, and the charge drainage transistor GD2 shown in Fig. 7A. In Fig. 7B, the horizontal axis indicates a position in the regions, and the vertical axis indicates a potential level (the potential is higher at a lower position).

Fig. 7B shows a potential state when a gate voltage at the "H" level is applied to the gate GD1_G of the charge drainage transistor GD1 and similarly, a gate voltage at the "H" level is applied to the gate GD2_G of the charge drainage transistor GD2.

The gate GD1_G of the charge drainage transistor GD1 is at the "H" level; thus, the potential is high (no potential barrier is formed) in the region of the gate GD1_G, and the charge carriers are transferred from the photoelectric conversion device PD to the drain GD1_D of the charge drainage transistor GD1 (the electrons are discharged to the power supply VDD connected to the drain GD1_D).

On the other hand, the gate GD2_G of the charge drainage transistor GD2 is at the "H" level; thus, as in the gate GD1_G of the charge drainage transistor GD1, no potential barrier is formed in the region of the gate GD2_G, and the charge carriers are transferred from the photoelectric conversion device PD to the drain GD1_D of the charge drainage transistor GD 1.

When charge carriers at the "H" level is applied to each of the gates GD1_G and GD2_G of the charge drainage transistors GD1 and GD2, the potential drops from the source (the n-type diffusion layer of the photoelectric conversion device PD) to the drains GD1_D and GD2_D have the same shape (potential slope). This is because the charge drainage transistors GD1 and GD2 are located at the same distance from the center O of the photoelectric conversion device PD.

In addition, since the charge drainage transistors GD1 and GD2 are located on the y-axis, the distances from the center O of the photoelectric conversion device PD to the gates GD1_G and GD2_G are small. Therefore, when charge carriers at the "H" level is applied to each of the gates GD1_G and GD2_G of the charge drainage transistors GD 1 and GD2, a steep potential drop can be achieved from the source (the n-type diffusion layer of the photoelectric conversion device PD) to the drains GD1_D and GD2_D. This creates a state in which charge carriers can move easily. This improves the drainage characteristics by facilitating drainage of charge carriers, and reduces the risk of a drainage failure during drainage.

<Second Embodiment>

A second embodiment of the present invention will be described with reference to the drawings. This embodiment differs from the embodiment described above in that the channel length of the transfer transistors G is longer than the channel length of the charge drainage transistors GD.

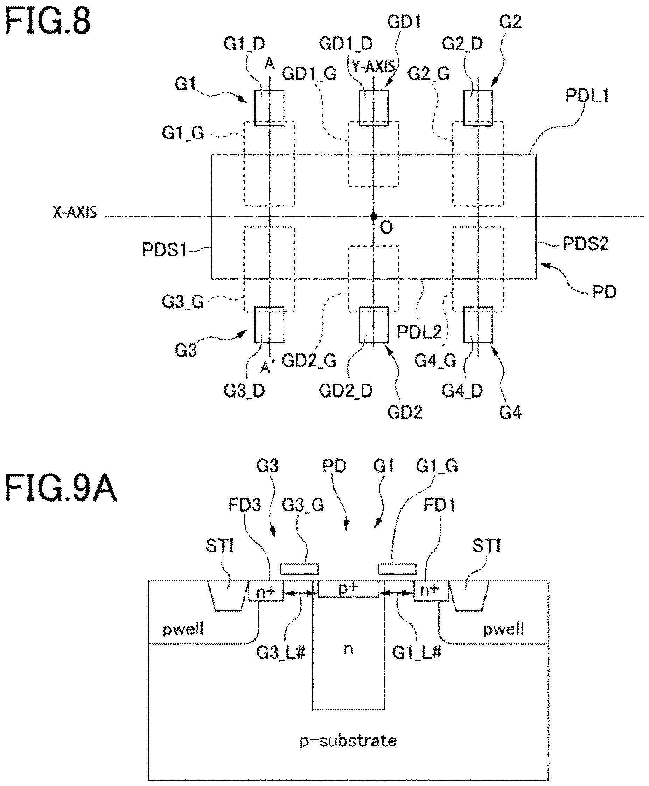

Fig. 8 is a diagram showing an example of a positional relationship between the photoelectric conversion device PD, the transfer transistors G, and the charge drainage transistors GD in the pixel circuits 321 of the present embodiment.

As shown in Fig. 8, the gate size (length in the y-axis direction) of the respective gates G1_G, G2_G, G3_G, and G4_G of the transfer transistors G1, G2, G3, and G4 is longer than the gate size of the charge drainage transistors GD.

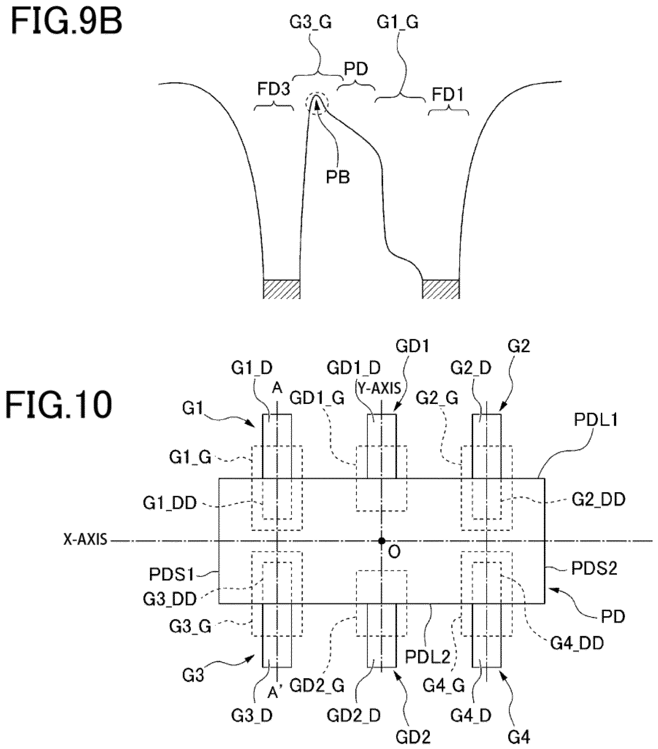

Figs. 9A and 9B are each a diagram illustrating the transfer of charge carriers from the photoelectric conversion device PD to the floating diffusions FD performed by the transfer transistors G according to the present embodiment.

Fig. 9A shows a cross-sectional structure taken along line segment A-A' of the semiconductor on which the pixel circuit 321 in Fig. 8 is provided.

The transfer transistor G1 is formed so that the length from the source to the drain is a channel length G1_L#. The channel length G1_L# is larger than channel lengths GD1_L and GD2_L in Fig. 7A.

The transfer transistor G3 is formed so that the length from the source to the drain is a channel length G3_L#. The channel length G3_L# is larger than channel lengths GD1_L and GD2_L in Fig. 7A.

Fig. 9B shows a potential state in the regions of the transfer transistor G1, the photoelectric conversion device PD, and the transfer transistor G3 shown in Fig. 9A. In Fig. 9B, the horizontal axis indicates a position in the regions, and the vertical axis indicates a potential level (the potential is higher at a lower position).

Fig. 9B shows a potential state when a gate voltage at the "H" level is applied to the gate G1_G of the transfer transistor G1 and a gate voltage at an "L" level is applied to the gate G3_G of the transfer transistor G3.

The gate G1_G of the transfer transistor G1 is at the "H" level; thus, the potential is high in the region of the gate G1_G, and charge carriers are transferred from the photoelectric conversion device PD to the floating diffusion FD1 as a drain of the transfer transistor G1.

In this case, since the channel length G1_L# is larger than the channel lengths GD1_L and GD2_L, when a gate voltage of the "H" level is applied to the gate G1_G of the transfer transistor G1, an electric field can be created in the x-axis direction that is stronger than that of the first embodiment. This improves the transfer characteristics by facilitating transfer of charge carriers, and reduces the risk of a transfer failure during transfer.

<Third Embodiment>

A third embodiment of the present invention will be described with reference to the drawings. This embodiment differs from the above-described embodiments in that the transfer transistors G are doped (added) with n-type impurities.

Fig. 10 is a diagram showing an example of a positional relationship between the photoelectric conversion device PD, the transfer transistors G, and the charge drainage transistors GD in the pixel circuits 321 of the present embodiment.

As shown in Fig. 10, doped regions G1_DD, G2_DD, G3_DD, and G4_DD are formed by entirely or partially doping the channel regions of the respective drains G1_D, G2_D, G3_D, and G4_D of the transfer transistors G1, G2, G3, and G4 with n-type impurities.

By forming the doping regions G1_DD, G2_DD, G3_DD, and G4_DD, even if the channel length G_L of the transfer transistors G is large, the channel regions can be provided with a high potential gradient when a gate voltage of the "H" level is applied to the gates G_G. This facilitates transfer of charge carriers in the transfer transistors G so that transfer traps can be prevented.

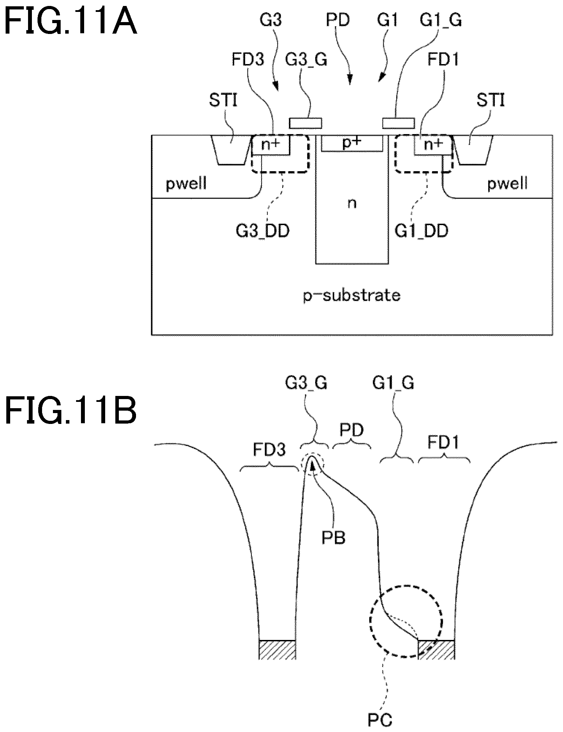

Figs. 11A and 11B are each a diagram illustrating the transfer of charge carriers from the photoelectric conversion device PD to the floating diffusions FD performed by the transfer transistors G according to the present embodiment.

Fig. 11A shows a cross-sectional structure taken along line segment A-A' of the semiconductor on which the pixel circuit 321 in Fig. 10 is provided.

The doped region G1_DD is formed by doping, with n-type impurities, the region between the n-type diffusion layer (source) of the photoelectric conversion device PD and the n+ diffusion layer (drain) of the floating diffusion FD1, and the region surrounding the n+ diffusion layer of the floating diffusion FD1.

The doped region G3_DD is formed by doping, with n-type impurities, the region between the n-type diffusion layer (source) of the photoelectric conversion device PD and the n+ diffusion layer (drain) of the floating diffusion FD3, and the region surrounding the n+ diffusion layer of the floating diffusion FD3.

Fig. 11B shows a potential state in the regions of the transfer transistor G1, the photoelectric conversion device PD, and the transfer transistor G3 shown in Fig. 11A. In Fig. 11B, as in Fig. 6B, the horizontal axis indicates a position in the regions, and the vertical axis indicates a potential level (the potential is higher at a lower position).

Similarly to Fig. 6B, Fig. 11B shows a potential state when a gate voltage at the "H" level is applied to the gate G1_G of the transfer transistor G1 and a gate voltage at an "L" level is applied to the gate G3_G of the transfer transistor G3.

Fig. 11B shows that a potential curve PC is formed in a region extending from the gate G1_G to the floating diffusion FD1. The solid line of the potential curve PC indicates the potential state of this embodiment. The dotted line of the potential curve PC indicates the potential state in Fig. 6B. In this embodiment, since the doped region G1_DD is formed from the gate G1_G to the floating diffusion FD1, the potential curve PC is formed in which the potential (potential) rises more steeply than in Fig. 6B.

<Fourth Embodiment>

Hereinafter, with reference to the drawings, a fourth embodiment of the present invention will be described.

The fourth embodiment is a range imaging device (range imaging sensor 32) of the range imaging apparatus having the same configuration as that in Fig. 2, and is configured such that the pixel circuits 321 as shown in Fig. 4 are each provided with a condenser microlens.

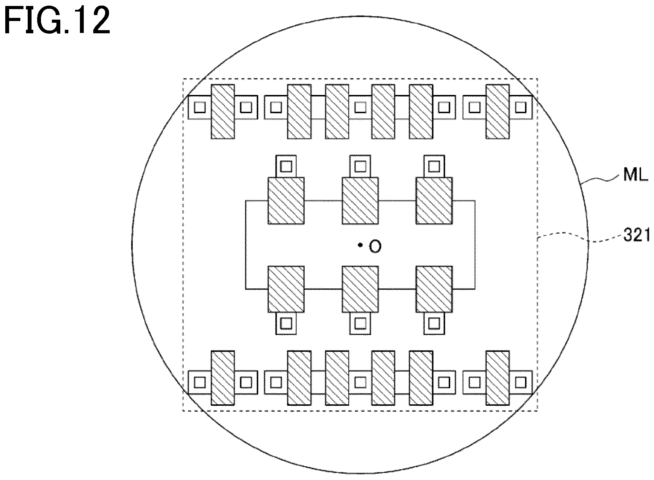

Fig. 12 is a diagram showing a positional relationship between the photoelectric conversion device PD and a microlens ML of the pixel circuits 321.

Microlenses ML are formed by thermal shaping of a predetermined resin material, and are provided to overlap in plan view with the regions in which the pixel circuits 321 are arranged.

The microlenses ML are provided in the respective pixel circuits 321 so that the optical axes of the microlenses ML (the centers of the microlenses ML) overlap with the centers O of the photoelectric conversion devices PD in plan view.

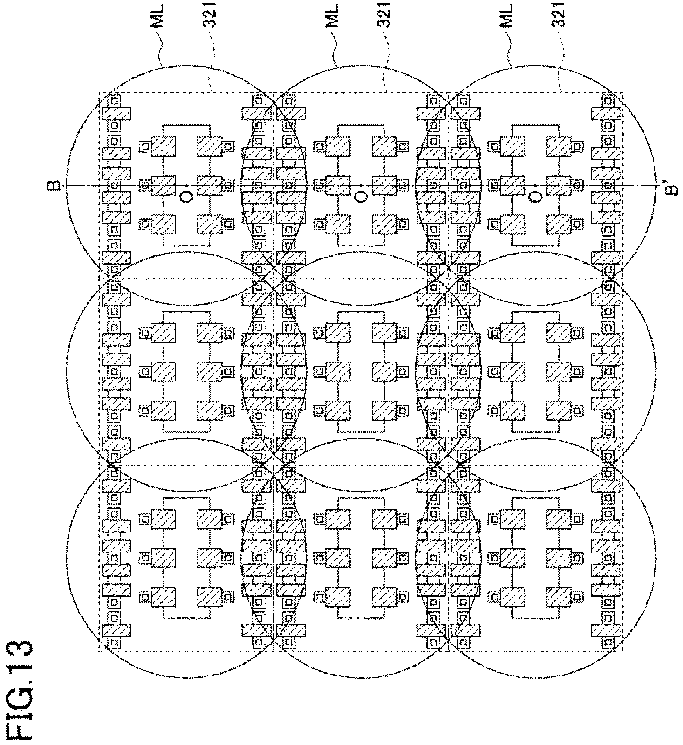

Fig. 13 is a plan view showing a lens array in a portion of the light receiving region 320 in which the plurality of pixel circuits 321 are arranged.

Fig. 13 shows a positional relationship between the pixel circuits 321 and the microlenses ML that are arranged as a lens array in a portion of the light receiving region 320 with a 3 × 3 matrix of pixel circuits 321.

The optical axis of each of the microlenses ML of the microlens array overlaps with the center O of one of the pixel circuits 321 that overlaps with the corresponding one of the microlenses ML in plan view. Note that the center O of a pixel circuit 321 may be the center of the incident surface of the photoelectric conversion device PD.

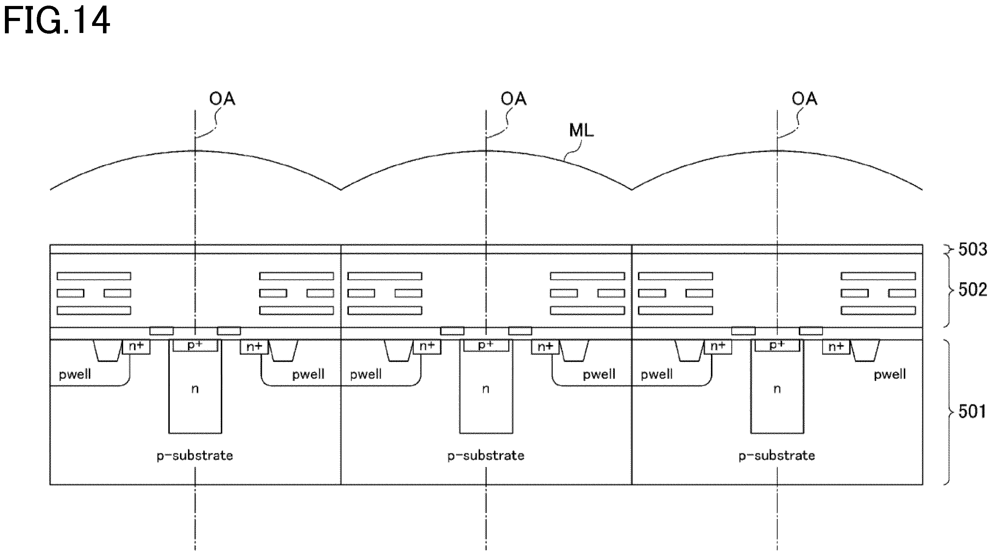

Fig. 14 is a cross-sectional view of the lens array of the pixel circuits 321 provided with the microlenses ML in Fig. 13.

Fig. 14 shows the shape of a cross section of the array of the pixel circuits 321 taken along line segment B-B' in Fig. 13. The range imaging sensor 32 as a range imaging device in Fig. 14 is an FSI (front side illumination) sensor in which light is incident on a surface provided with photodiodes which are the photoelectric conversion devices PD.

A wiring layer 502 that is insulated by an insulating layer is provided above a semiconductor layer 501, and a dielectric layer 503 as a passivation layer is provided above the wiring layer 502. The lens array of the microlenses ML (microlens array) is provided above the dielectric layer 503.

An optical axis OA of each of the microlenses ML of the microlens array is perpendicular to a surface (incident surface) of the photoelectric conversion device PD in the semiconductor layer 501, and passes through the center O of one of the pixel circuits 321 that overlaps with the corresponding one of the microlenses ML in plan view.

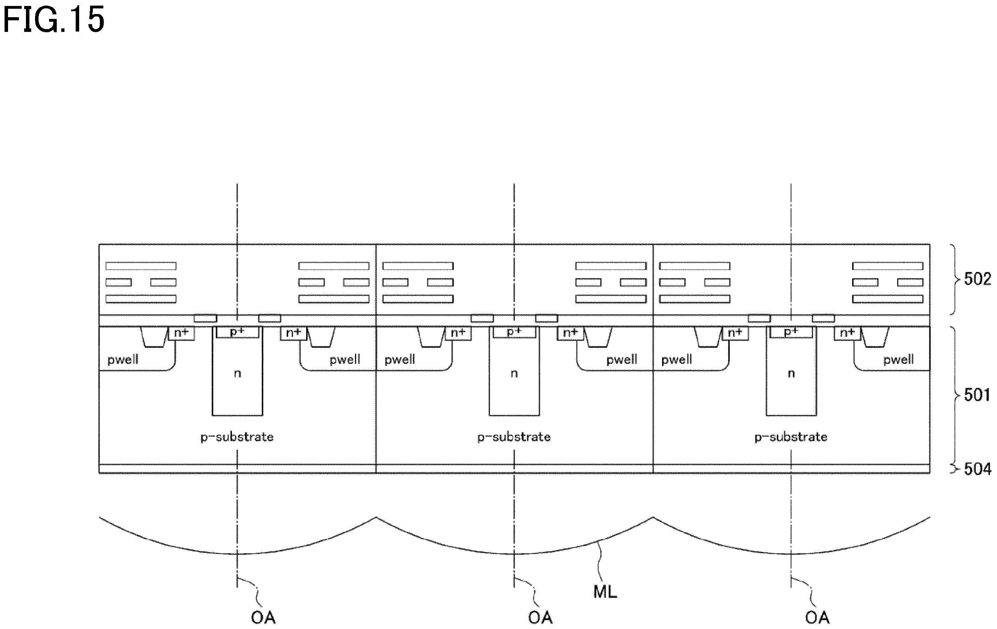

Fig. 15 is a cross-sectional view of the lens array of the pixel circuits 321 provided with the microlenses ML in Fig. 13.

Fig. 15 shows the shape of a cross section of the lens array of the pixel circuits 321 taken along line segment B-B' in Fig. 13. The range imaging sensor 32 as a range imaging device in Fig. 15 is an BSI (back side illumination) sensor in which light is incident on the back surface provided with photodiodes which are the photoelectric conversion devices PD.

A wiring layer 502 that is insulated by an insulating layer is provided above the semiconductor layer 501, and a dielectric layer 504 as a passivation layer is provided below the semiconductor layer 501. The lens array of the microlenses ML is provided below the dielectric layer 504.

The optical axis OA of each of the microlenses ML of the lens array is perpendicular to a surface of the photoelectric conversion device PD in the semiconductor layer 501, and passes through the center O of one of the pixel circuits 321 that overlaps with the corresponding one of the microlenses ML in plan view.

With the configuration described above, in the present embodiment, the microlenses ML allow light incident on the pixel circuits 321 to be condensed and incident on the photoelectric conversion devices PD, and this enables efficient photoelectric conversion of the light incident on the pixel circuits 321, achieving higher sensitivity to the incident light.

In the present embodiment, the arrangement of the microlenses ML with respect to the pixel circuits 321 of the first embodiment is described; however, this can be also applied to the pixel circuits 321 of the second and third embodiments to allow the pixel circuits 321 to have higher sensitivity to incident light.

Note that the technical scope of the present invention is not limited to the above embodiments, and can be appropriately modified within a range not departing from the spirit of the present invention.

Components of the above-described embodiments may be replaced with well-known components as appropriate, and the above-described embodiments and modifications may be combined as appropriate within a range not departing from the spirit of the present invention.

[Reference Signs List]

1 ... Range imaging apparatus
2 ... Light source unit
3 ... Light receiving unit
31 ... Lens
32 ... Range imaging sensor (range imaging device)
321 ... Pixel circuit
322 ... Control circuit
323 ... Vertical scanning circuit
324 ... Horizontal scanning circuit
325 ... Pixel signal processing circuit
4 ... Distance image processing unit
41 ... Timing controller
42 ... Distance calculator
CS ... Charge storage
FD1, FD2, FD3, FD4 ... Floating diffusion

G1, G2, G3, G4 ... Transfer transistor
GD1, GD2 ... Charge drainage transistor
ML ... Microlens
PD ... Photoelectric conversion device
PO ... Light pulse
RT1, RT2, RT3, RT4 ... Reset transistor
S ... Subject
SF1, SF2, SF3, SF4 ... Source follower transistor
SL1, SL2, SL3, SL4 ... Selection transistor

**Claims**

1. A range imaging device formed on a semiconductor substrate, the range imaging device comprising:

   a photoelectric conversion device configured to generate charge carriers based on light incident from a space targeted for measurement;
   charge storages each configured to store at least some of the generated charge carriers;
   at least one transfer transistor provided on a transfer path, the at least one transfer transistor being configured to transfer at least some of the generated charge carriers from the photoelectric conversion device to a corresponding one of the charge storages through the transfer path; and
   at least one charge drainage transistor provided on a drainage path, the at least one charge drainage transistor being configured to drain the generated charge carriers from the photoelectric conversion device through the drainage path,
   wherein
   a pixel circuit is formed at a surface of the semiconductor substrate, the pixel circuit including at least the photoelectric conversion device, the charge storages, the transfer transistor, and the charge drainage transistor,
   the photoelectric conversion device has a rectangular shape in plan view on the surface of the photoelectric conversion device,
   the at least one charge drainage transistor includes two charge drainage transistors, and
   when, in a plan view, an axis that is parallel to long sides of the photoelectric conversion device and passes through a center of the photoelectric conversion device is set as an x-axis, and an axis that is parallel to short sides of the photoelectric conversion device and passes through the center of the photoelectric conversion device is set as a y-axis,
   the two charge drainage transistors are provided on the y-axis, and
   the two charge drainage transistors are arranged symmetrically with respect to the x-axis and face each other

2. The range imaging device according to claim 1, wherein

   the at least one transfer transistor includes 2M transfer transistors (M being an integer greater than or equal to 2), and
   M transfer transistors of the 2M transfer transistors are arranged on each of long sides symmetrically with respect to the x-axis, the M transfer transistors on one of the long sides facing the M transfer transistors on the other of the long sides.

3. The range imaging device according to claim 1 or 2, wherein
   the at least one transfer transistors has a channel length longer than that of the charge drainage transistors.

4. The range imaging device according to any one of claims 1 to 3, wherein
   the at least one transfer transistor has a channel region that is entirely or partially channel-doped with n-type impurities.

5. The range imaging device according to any one of claims 1 to 4, further comprising:
   a microlens facing a surface of the pixel circuit, the surface of the pixel circuit being arranged to receive the light, the microlens having an optical axis that is perpendicular to an entrance surface of the photoelectric conversion device and passes through a center of the entrance surface, the entrance surface being arranged to receive the light.

6. A range imaging apparatus comprising:

a light receiving unit including the range imaging device according to any one of claims 1 to 5; and
a distance image processing unit configured to obtain a distance from the range imaging device to a subject based on a distance image captured by the range imaging device.

EP 4 492 085 A1

# FIG.1

# FIG.2

323

32

VERTICAL SCANNNING CIRCUIT

320

321

CONTROL CIRCUIT

322

PIXEL SIGNAL PROCESSING CIRCUIT — 325

HORIZONTAL SCANNING CIRCUIT — 324

# FIG.3

FIG.4

FIG.5

FIG.6A

FIG.6B

G3_G    G1_G

FD3    PD    FD1

PB

FIG.7A

GD1_D    GD1_G / GD1    GD2    GD2_D
VDD    GD2_G    VDD
PD
STI    STI

n+    p+    n+

pwell    pwell

GD1_L    n    GD2_L

p-substrate

FIG.7B

GD1_G    GD2_G
GD1_D    PD    GD2_D

FIG.8

FIG.9A

# FIG.9B

# FIG.10

# FIG.11A

# FIG.11B

FIG.12

ML

321

O

FIG.13

FIG.14

# FIG.15

EP 4 492 085 A1

## INTERNATIONAL SEARCH REPORT

International application No.

**PCT/JP2023/008309**

### A. CLASSIFICATION OF SUBJECT MATTER

*G01S 7/4863*(2020.01)i; *G01C 3/06*(2006.01)i; *G01S 17/89*(2020.01)i; *H01L 27/146*(2006.01)i
FI:   G01S7/4863; G01S17/89; G01C3/06 120Q; H01L27/146 A

According to International Patent Classification (IPC) or to both national classification and IPC

### B. FIELDS SEARCHED

Minimum documentation searched (classification system followed by classification symbols)

G01S7/48 - G01S7/51; G01S17/00 - G01S17/95; G01C3/00 - G01C3/32; H01L27/146; H04N25/705

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2021-34496 A (SONY SEMICONDUCTOR SOLUTIONS CORP.) 01 March 2021 (2021-03-01)<br>        entire text, all drawings | 1-6 |
| A | JP 2021-197388 A (SONY SEMICONDUCTOR SOLUTIONS CORP.) 27 December 2021 (2021-12-27)<br>        entire text, all drawings | 1-6 |
| A | JP 7014324 B1 (TOPPAN PRINTING CO., LTD.) 15 February 2022 (2022-02-15)<br>        entire text, all drawings | 1-6 |
| A | US 2021/0199781 A1 (SAMSUNG ELECTRONICS CO., LTD.) 01 July 2021 (2021-07-01)<br>        entire text, all drawings | 1-6 |

☐ Further documents are listed in the continuation of Box C.      ☑ See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| **18 April 2023** | **09 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/008309**

| Patent document cited in search report | | | Publication date (day/month/year) | Patent family member(s) | | | Publication date (day/month/year) |
|---|---|---|---|---|---|---|---|
| JP | 2021-34496 | A | 01 March 2021 | US | 2022/0291347 | A1 | |
| | | | | entire text, all drawings | | | |
| | | | | WO | 2021/033576 | A1 | |
| | | | | TW | 202109081 | A | |
| | | | | CN | 114207827 | A | |
| | | | | KR | 10-2022-0047767 | A | |
| JP | 2021-197388 | A | 27 December 2021 | WO | 2021/251152 | A1 | |
| | | | | entire text, all drawings | | | |
| | | | | CN | 115699317 | A | |
| JP | 7014324 | B1 | 15 February 2022 | WO | 2022/185967 | A1 | |
| | | | | entire text, all drawings | | | |
| US | 2021/0199781 | A1 | 01 July 2021 | KR | 10-2021-0084752 | A | |
| | | | | CN | 113050065 | A | |

Form PCT/ISA/210 (patent family annex) (January 2015)

**EP 4 492 085 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022034960 A

- JP 4235729 B